# EUROPEAN PATENT APPLICATION

(11) **EP 4 734 700 A1**
(43) Date of publication of application: **29.04.2026**
(21) Application number: 24208103.2
(22) Date of filing: 22.10.2024
(51) Int. Cl.: H10D 62/10, H10D 30/01, H10D 30/43, H10D 30/00, H10D 84/01, H10D 84/03, H10D 84/83

(54) **A CO-INTEGRATED SEMICONDUCTOR STRUCTURE, AND A METHOD FOR MANUFACTURING A CO-INTEGRATED SEMICONDUCTOR STRUCTURE**

(71) Applicant: Imec VZW, 3001 Leuven (BE)
(72) Inventor: CHAN, Boon Teik, 3012 Wilsele (BE); HORIGUCHI, Naoto, 3000 Leuven (BE)
(74) Representative: AWA Sweden AB

(57) **Abstract**

A method for manufacturing a co-integrated semiconductor structure (1) from a first (100) and a second (200) layer stack,
the first layer stack (100) comprising a channel layer (10) and at least one sub-stack (150) on the channel layer (10), wherein each of the at least one sub-stack (150) comprises a sacrificial layer of a first type (21), a first slender layer (31) on the sacrificial layer of the first type (21), a sacrificial layer of a second type (22) on the first slender layer (31), a second slender layer (32) on the sacrificial layer of the second type (22), a further sacrificial layer of the first type (21) on the second slender layer (32), and a further channel layer (10) on the further sacrificial layer of the first type (21),
the second layer stack (200) comprising a channel layer (10) and at least one sub-stack (250) on the channel layer (10), wherein each of the at least one sub-stack (250) comprises a sacrificial layer of the first type (21) and a further channel layer (10, 11) on the sacrificial layer of the first type (21),
wherein a separation (S1) between the neighboring channel layers (10) of the first layer stack (100) is larger than a separation (S2) between neighboring channel layers (10) of the second layer stack (200).

## Description

### TECHNICAL FIELD

The present inventive concept relates, in general, to a method for manufacturing a co-integrated semiconductor structure.

### BACKGROUND

Co-integrated semiconductor structures are semiconductor structures integrated on the same substrate. Examples of co-integrated semiconductor structures are co-integrated transistors, e.g. core transistors and Input/Output (I/O) transistors integrated on the same substrate and forming an electrical circuit. The core transistors execute instructions and/or process data and/or perform logical operations. The core transistors may alternatively be called logic transistors or primary transistors. The I/O transistors manage input and output signals to and from the electrical circuit.

### SUMMARY

It is an objective of the present inventive concept to facilitate co-integration of semiconductor structures. In particular, it is an objective to facilitate co-integration of transistors with differing current flows (or facilitate co-integration of semiconductor structures that can be used to manufacture co-integrated transistors with differing current flows). In particular, it is an objective to facilitate co-integration of an I/O transistor and a core transistor on a same substrate. It is a realization that an I/O transistor often carry a larger current than a core transistor.

It is an objective to facilitate high-quality co-integrated transistors. In particular, it is an objective to facilitate co-integrated transistors with low parasitic capacitance and/or low leakage current. In particular, it is an objective to facilitate co-integrated transistors with high-quality inner spacers. In particular, it is an objective to facilitate co-integrated transistors with little or no plasma damage or implant damage.

It is an objective to facilitate efficient production of co-integrated transistors. In particular, it is an objective to facilitate cost-efficient production of co-integrated transistors and/or facilitate a lean production of co-integrated transistors (e.g. facilitate production requiring few process tools).

In the following, relative spatial terms such as "top", "bottom", "lower", "vertical", "stacked on top of", are to be understood as denoting locations or directions within a frame of reference of the co-integrated semiconductor structure. In particular, the terms may be understood in relation to a normal direction to a substrate on which stacks of layers are formed. Correspondingly, terms such as "lateral" and "horizontal" are to be understood as locations or directions parallel to the substrate.

According to a first aspect, there is provided a method for manufacturing a co-integrated semiconductor structure, the method comprising
forming, on a same substrate, a first and a second layer stack,
   the first layer stack comprising a channel layer and at least one sub-stack on the channel layer, wherein each of the at least one sub-stack comprises a sacrificial layer of a first type, a first slender layer on the sacrificial layer of the first type, a sacrificial layer of a second type on the first slender layer, a second slender layer on the sacrificial layer of the second type, a further sacrificial layer of the first type on the second slender layer, and a further channel layer on the further sacrificial layer of the first type,
   the second layer stack comprising a channel layer and at least one sub-stack on the channel layer, wherein each of the at least one sub-stack comprises a sacrificial layer of the first type and a further channel layer on the sacrificial layer of the first type,
   wherein a separation between the neighboring channel layers of the first layer stack is larger than a separation between neighboring channel layers of the second layer stack;
   wherein the slender layers and the channel layers are formed of a same semiconductor channel material, the slender layers being thinner than the channel layers;
   wherein the sacrificial layers of the first type are formed of a first sacrificial semiconductor material different from the semiconductor channel material;
   wherein the sacrificial layer of the second type is formed of a second sacrificial semiconductor material different from the semiconductor channel material and different from the first sacrificial semiconductor material;
the method further comprising:
   removing, in a gate region of the first layer stack, the sacrificial layers of the first and second types and the first and second slender layers of the first layer stack;
   removing, in a gate region of the second layer stack, the sacrificial layers of the first type of the second layer stack; and
   thereafter
      forming a gate stack around the channel layers in the gate region of the first layer stack;
      forming a gate stack around the channel layers in the gate region of the second layer stack.

The first and second layer stack may be used for producing a first and a second transistor. As mentioned, the separation between the neighboring channel layers of the first layer stack is larger than the separation between neighboring channel layers of the second layer stack. It is a realization that the larger channel layer separation of the first layer stack makes the first layer stack suitable for forming a transistor intended to carry a large current, e.g. suitable for forming an I/O transistor. Extra space between the channel layers provides extra room for other transistor parts, e.g. extra room for dielectric material. For example, extra room may be provided for a thick gate dielectric. Such thick dielectric material may facilitate a low leakage current.

In accordance with the above, the method may further comprise:
incorporating the channel layers of the first layer stack in a first transistor; and
incorporating the channel layers of the second layer stack in a second transistor. Accordingly, a separation between the neighboring channel layers of the first transistor may be larger than a separation between neighboring channel layers of the second transistor.

In particular, the method may further comprise:
incorporating the channel layers of the first layer stack in an Input/Output, I/O, transistor; and
incorporating the channel layers of the second layer stack in a core transistor.

Also in accordance with the above, a dielectric of the gate stack around the channel layers of the first layer stack may be thicker than a dielectric of the gate stack around the channel layers of the second layer stack. The dielectric of the gate stack may comprise several layers, e.g. an interface layer and a high-k dielectric layer. The interface layer may comprise SiO or SiO₂. The high-k dielectric layer may comprise HfO₂.

The dielectric of the gate stack around the channel layers of the first layer stack may have a thickness in the range 2.0-8.0 nm, e.g. 2.5-7.5 nm .

The dielectric of the gate stack around the channel layers of the second layer stack may have a thickness in the range 1.5-3.0 nm, advantageously in the range 2.0-2.6 nm. The dielectric of the gate stack around the channel layers of the second layer stack may comprise a 0.7 nm interface layer and a 1.3-1.9 nm HfO₂ Layer..

The gate stack may be arranged in a gate all around (GAA) arrangement.

As mentioned, the sacrificial layers of the first type are formed of a first sacrificial semiconductor material different from the semiconductor channel material. For example, the first sacrificial semiconductor material may have a composition different from the composition of the semiconductor channel material.

As mentioned, the sacrificial layer of the second type is formed of a second sacrificial semiconductor material different from the semiconductor channel material and the first sacrificial semiconductor material. For example, the second sacrificial semiconductor material may have a composition different from the composition of the semiconductor channel material, and also different from the composition of the first sacrificial semiconductor material.

As mentioned, the slender layers and the channel layers are formed of a same semiconductor channel material. Further, the slender layers are thinner than the channel layers. The slender layers may alternatively be called liner layers.

For example, the method may be configured such that the semiconductor channel material of the channel layers and the slender layers is Si₁₋ₐGeₐ, the first sacrificial semiconductor material is Si_{1-b}Ge_{b}, and the second sacrificial semiconductor material is Si_{1-c}Ge_{c}, wherein 0 ≤ a < b < c.

The use of different semiconductor materials facilitate selective etching of the sacrificial layers of the first and second type, e.g. facilitate faster etching (e.g. faster recessing) of sacrificial layers of the second type than sacrificial layers of the first type.

Composition ranges for the above mentioned Si₁₋ₐGeₐ, Si_{1-b}Ge_{b}, and Si_{1-b}Ge_{b} may be:
0 ≤ a < 0.05;
0.12 ≤ b ≤ 0.25; and
0.30 ≤ c ≤ 0.60.

These ranges may facilitate sufficient material contrast. To exemplify, the semiconductor channel material may be silicon (e.g. pure silicon), the first sacrificial semiconductor material may be silicon germanium with low germanium content, and the second sacrificial semiconductor material may be silicon germanium with high germanium content.

As described above, the first and the second layer stack may be used to form a first and a second transistor. The separation between the neighboring channel layers of the first layer stack is larger than the separation between neighboring channel layers of the second layer stack and accordingly the separation between the neighboring channel layers of the first transistor is larger than the separation between neighboring channel layers of the second transistor. This is in contrast to prior art methods where two identical layer stacks are used as a starting point to produce the two transistors with differing separation between neighboring channel layers. In such prior art methods, every second channel layer of one of the layer stacks is doped by ion implantation and later removed by an etch selective to said doping.

A first advantage of the method of the invention is that it facilitates production of co-integrated transistors without the need for ion implantation. Thus, co-integrated transistors with little or no implantation damage may be produced. This in turn facilitates production of high-quality co-integrated transistors, e.g. co-integrated transistors with low leakage current. Further, the method reduces or removes the need for ion implantation tools.

A second advantage of the method is that it facilitates production of co-integrated transistors with high-quality inner spacers. In particular, it facilitates high-quality inner spacers on the first layer stack (which has a large separation between neighboring channel layers).

Inner spacers are structures of dielectric material used to isolate the gate of a transistor from the source/drain regions.

As will be described further below, inner spacers may be formed by forming lateral recesses by laterally etching back the end surfaces of the sacrificial semiconductor material between the channel layers of a layer stack and filling said lateral recesses with dielectric material.

It is a realization that if the separation between neighboring channel layers is large and if a single sacrificial semiconductor material is used between neighboring channel layers, the lateral recess may have a rounded profile, e.g. parabolic profile. Further, the depth of the lateral recess may be hard to control.

It is a realization that the method facilitates lateral recesses with a staggered profile on the first layer stack. During the lateral etch back, the second sacrificial semiconductor material may etch faster than the first sacrificial semiconductor material, thereby forming a deeper lateral recess at the centre between the neighbouring channel layers than immediately adjacent the channel layers. Such an inner spacer with staggered profile may have a low parasitic capacitance between the gate and the source/drain. Additionally, or alternatively, such an inner spacer with staggered profile may provide stability to the first layer stack (which has a large separation between neighboring channel layers) during the production, e.g. during release of the channel layers of the first layer stack (i.e. during the step of removing, in a gate region of the first layer stack, the sacrificial layers of the first and second types and the first and second slender layers of the first layer stack).

It is a further realization that the method facilitates a staggered profile with sharp rather than rounded steps. Herein, the slender layers of the first layer stack may protect the sacrificial layers of the first type during the lateral etch back. As mentioned, the second sacrificial semiconductor material may etch faster than the first sacrificial semiconductor material and form a deeper lateral recess. It is a realization that without the slender layers between the first and second sacrificial material, the etchant may attack the first sacrificial semiconductor material in a vertical direction, via the deep recess left by the removed second sacrificial material. This may cause rounding of the steps of the staggered profile. It is a realization that the slender layers prevent or reduce vertical etching via the deep recess and thereby prevent or reduce rounding of the steps of the staggered profile.

A third advantage of the method is that parts of the first and second layer stack may be produced simultaneously. This facilitates a lean production of co-integrated transistors. Simultaneous formation of parts of the first and second layer stack will be discussed further below.

The first and second layer stacks may be seen as respective fins comprising the above described layers. Each layer stack, e.g. each fin, may comprise two opposing lateral side faces, two opposing lateral end faces, and a top face.

Forming the first and second layer stacks may comprise epitaxial growth of the layers on the substrate. The layers for the first layer stack may be grown on one part of the substrate and the layers for the second layer stack may be grown on another part of the substrate. The grown layers on the respective parts of the substrate may then be shaped into the above mentioned fins, e.g. by lithographical patterning and etching.

The layers for the first layer stack may be grown on a part of the substrate that is peripheral to the part of the substrate on which the layers for the second layer stack are grown. Thus, after dicing, transistors based on first layer stacks (suitable I/O transistors) may be arranged at the periphery of the dice and transistors based on second layer stacks (suitable core transistors) may be arranged at the center of the dice.

The step of removing, in the gate region of the first layer stack, the sacrificial layers of the first and second types and the first and second slender layers of the first layer stack, may alternatively be called releasing the channel layers of the first layer stack.

The step of removing, in a gate region of the second layer stack, the sacrificial layers of the first type of the second layer stack, may alternatively be called releasing the channel layers of the second layer stack.

Releasing the channel layers of the first layer stack may be performed simultaneously with releasing the channel layers of the second layer stack.

The gate region is the region where the gate of the finished transistor is arranged. As mentioned, a gate stack is formed around the channel layers in the gate region of the first layer stack and a gate stack is formed around the channel layers in the gate region of the second layer stack. The gate stack around the channel layers of the first layer stack may additionally be formed on top of the first layer stack. The gate stack around the channel layers of the second layer stack may additionally be formed on top of the second layer stack. Each gate stack may comprise a gate dielectric layer followed by a gate work function metal (WFM) conformally coating the released channel layers in the gate region. The gate dielectric layer may comprise several layers, e.g. an interface layer and a high-k dielectric layer. Each gate stack may be arranged in a gate all around (GAA) configuration around the channel layers of the respective layer stack.

The gate stack around the channel layers of the first layer stack and the gate stack around the channel layers of the second layer stack may be formed simultaneously or separately. For example, the gate dielectric layer of the gate stack around the channel layers of the first layer stack and the gate dielectric layer of the gate stack around the channel layers of the second layer stack may be formed separately, to facilitate different thicknesses.

The gate stack around the channel layers of the first layer stack and the gate stack around the channel layers of the second layer stack may be formed in a gate-last process, e.g. by using a replacement gate (also known as a dummy gate) during early stages of the transistor manufacturing. Alternatively, the gate stack around the channel layers of the first layer stack and the gate stack around the channel layers of the second layer stack may be formed in a gate-first process.

In the following, the step of forming the layer stacks will be described further. Simultaneous formation of parts of the first and second layer stack will be discussed first.

The method may be configured such that the channel layer of at least one of the at least one sub-stack of the second layer stack is a multi-layer channel layer, the multi-layer channel layer being formed from at least a first and a second slender layer,
the first slender layer of the multi-layer channel layer of the second layer stack being formed simultaneously with the first slender layer of the first layer stack; and
the second slender layer of the multi-layer channel layer of the second layer stack being formed simultaneously with the second slender layer of the first layer stack.

As mentioned, this facilitates a lean production of co-integrated transistors. In particular, this facilitates a lean production of co-integrated transistors with high-quality inner spacers and little or no implantation damage. The slender layers of the first layer stack may facilitate the advantageous staggered inner spacer profile with sharp corners for the first layer stack, discussed above. The slender layers of the second layer stack may collectively form a channel layer in the form of the multi-layer channel layer. In other words, even if each slender layer on its own may be too thin to form a good channel layer, the first and second slender layers (potentially together with further slender layers) may together form a sufficiently thick multi-layer channel layer.

To exemplify further, forming the first and second layer stacks may comprise:
forming, simultaneously, the first slender layer of the first layer stack and the first slender layer of the multi-layer channel layer of the second layer stack;
subsequently, simultaneously forming the sacrificial layer of the second type on the first slender layer of the first layer stack and the sacrificial layer of the second type on the first slender layer of the multi-layer channel layer of the second layer stack;
subsequently removing the sacrificial layer of the second type from the first slender layer of the multi-layer channel layer of the second layer stack;
subsequently forming, simultaneously, the second slender layer of the first layer stack and the second slender layer of the multi-layer channel layer of the second layer stack.

In accordance with the above, the multi-layer channel layer of the second layer stack may comprise a first slender layer and a second slender layer on the first slender layer. For example, if no further layers are formed between the first and second slender layers of the multi-layer channel layer of the second layer stack, second layer stack may comprise a first slender layer and a second slender layer on the first slender layer.

Alternatively, the multi-layer channel layer of the second layer stack may comprise a third slender layer sandwiched between the first and second slender layer. In other words, the multi-layer channel layer of the second layer stack may comprise a first slender layer, a third slender layer on the first slender layer, and a second slender layer on the third slender layer.

Subsequently should be construed as meaning after but not necessarily immediately after.

Accordingly, the method may further comprise:
forming a third slender layer between the first and second slender layers of the multi-layer channel layer of the second layer stack.

As earlier mentioned, the layers may be formed by epitaxial growth. Layers that are removed may be removed by etching. The first layer stack may be masked during removal of layers of the second layer stack.

The act of removing the sacrificial layer of the second type from the first slender layer of the second layer stack may be performed by wet etching.

It is a realization that wet etching causes little damage to the remaining surface, e.g. results in a remaining surface suitable for further formation of layers, e.g. suitable for epitaxial growth.

The act of removing the sacrificial layer of the second type from the first slender layer of the second layer stack may be performed by selective etching, e.g. selective wet etching. Thus, when the sacrificial layer of the second type is removed from the first slender layer of the second layer stack, the first slender layer of the second layer stack may be unaffected. Thus, easy control of the thickness of the multi-layer channel layer is facilitated.

In order to remove the sacrificial layer of the second type from the first slender layer of the second layer stack by wet etching, a solution of tetramethylammonium hydroxide (TMAH) may be used. Alternatively, a mixture of hydrogen peroxide (H₂O₂), nitric acid (HNO₃), acetic acid (CH₃COOH), and hydrofluoric acid (HF) may be used.

As an alternative to wet etching, the sacrificial layer of the second type may be removed by dry etching. For example, the sacrificial layer of the second type may be removed from from the first slender layer of the second layer stack by e.g a gas phase plasma etch with F₂ gas mixtures.

As an alternative to simultaneous formation of parts of the first and second layer stack, the first and second layer stack may be formed separately.

To exemplify: The substrate may comprise a first and a second part. Layers for the second layer stack may be formed on the second part of the substrate, e.g. by epitaxial growth. Any material deposited on the first part of the substrate during formation of the layers for the second layer stack may then be removed, e.g. by etching. For example, a layer stack identical to the second layer stack on the second part of the substrate may be removed from the first part of the substrate. Then, layers for the second layer stack may be formed on the first part of the substrate. Separate formation of the first and second layer stacks can thus be a simple method.

Both simultaneous formation of parts of the first and second layer stack and separate formation of the first and second layer stacks are advantageous, at least in different situations.

Simultaneous formation of parts of the first and second layer stack is particularly advantageous as etching may be minimized. For example, there may be no need to remove an entire layer stack from a part of the substrate which could reduce the surface quality and affect further formation of layer stacks (e.g. by epitaxial growth).

The method may be configured such that the channel layers of the first and second layer stack have a same thickness. Thus, transistors based on first layer stacks may have the same or similar characteristics as transistors based on second layer stacks, albeit being suited for higher currents.

The thickness of the channel layers may be 4 - 10nm, preferably 5-7 nm.

To exemplify, if a channel layer of the second layer stack is formed as a multi-layer channel layer, then said multi-layer channel layer may have the same thickness as any channel layer of the first layer stack. If said multi-layer channel layer comprises solely a first and a second slender layer, then the sum of the thicknesses of said first and a second slender layers may be equal to the thickness of any channel layer of the first layer stack. If instead said multi-layer channel layer comprises solely a first, a second, and a third slender layer, then the sum of the thicknesses of said first, second and third slender layers may be equal to the thickness of any channel layer of the first layer stack.

In the following, formation of inner spacers will be discussed.

The method may comprise:
forming source/drain recesses, the source/drain recesses exposing end surfaces of the respective first and second layer stack;
   forming lateral recesses in the first layer stack by laterally etching back the end surfaces of the sacrificial layers of the first and second types from opposite ends of the first layer stack, by selective etching;
forming lateral recesses in the second layer stack by laterally etching back the end surfaces of the sacrificial layer of the first type from opposite ends of the second layer stack, by selective etching;
forming inner spacers between end parts of neighbouring channel layers of the respective first and second layer stacks, the inner spacers comprising dielectric material deposited in the lateral recesses;
wherein the lateral recesses of the first and second layer stacks are formed simultaneously and the inner spacers of the first and second layer stacks are formed simultaneously.

As discussed above, such formation of inner spacers may form inner spacers with staggered profile for the first layer stack.

The selective etching may be configured to have a low etch rate for channel layers and slender layers as compared to the etch rate of sacrificial layers of the first and second type. An example of a suitable etchant for the lateral etch back is NF₃ or F₂ chemistry mixture.

The method may be configured such that in the gate region of the first layer stack, the first and second slender layers are removed subsequent to removing the sacrificial layers of the first and second types. Accordingly, in the gate region of the first layer stack, the first and second slender layers may be trimmed. Thus, in the gate region of the first layer stack a free space may be created between the channel layers such that the gate stack may be arranged without any remaining slender layers. However, it should be understood that even if removing the sacrificial layers of the first and second types is performed with a selective etch which has a low etch rate on the channel layers and slender layers, the thickness of the slender layers may be small enough for them to be removed by said etch in the gate region anyway. In such a case the first and second slender layers may be removed during the removal of the sacrificial layers of the first and second types, in the gate region of the first layer stack. In such a case, trimming may not be necessary.

As discussed above, the layers for the first and second layer stack may be formed on different parts of the substrate. Accordingly, the method may comprise:
arranging the first layer stack at a peripheral part of the substrate; and
arranging the second layer stack at a central part of the substrate.

The method of the first aspect may be used to produce an advantageous co-integrated circuit, as discussed above. In particular, the method of the first aspect may be used to produce a co-integrated semiconductor structure, e.g. a co-integrated transistor pair.

Thus, according to a second aspect, there is provided a co-integrated semiconductor structure comprising, on a same substrate, a first and a second transistor,
the first transistor comprising
   a first layer stack comprising at least two channel layers;
   a gate stack around each of the two channel layers in a gate region of the first layer stack; and
   an inner spacer arranged vertically between end parts of the two channel layers of the first layer stack, the inner spacer of the first layer stack comprising a first lateral recess, a second lateral recess above the first lateral recess, and a third lateral recess above the second lateral recess, the first, second and third lateral recesses being filled with dielectric material;
the second transistor comprising
   a second layer stack comprising at least two channel layers;
   a gate stack around each of the two channel layers in a gate region of the second layer stack; and
   an inner spacer arranged vertically between end parts of two channel layers of the second layer stack, the inner spacer of the second layer stack comprising a first lateral recess filled with dielectric material;
   wherein a separation between neighboring channel layers of the first layer stack is larger than a separation between neighboring channel layers of the second layer stack; and
wherein the second lateral recess of the first layer stack is separated from the first and third lateral recesses of the first layer stack by respective slender layers, the slender layers and the channel layers of the first layer stack being formed of a same semiconductor channel material, the slender layers being thinner than the channel layers; or
wherein the second lateral recess of the first layer stack is deeper than the first and third lateral recesses of the first layer stack.

The co-integrated semiconductor structure may further be configured such that a dielectric of the gate stack of the first layer stack is thicker than a dielectric of the gate stack of the second layer stack.

A co-integrated circuit according to the second aspect may have the same advantages, or similar advantages, as the advantages described in conjunction with the first aspect.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 illustrates a first and a second layer stack according to the present invention.
Fig. 2 illustrates a method for manufacturing a co-integrated semiconductor structure according to the present invention.
Fig. 3 illustrates forming of a first and a second layer stack according to the present invention.
Fig. 4 illustrates forming of a first and a second layer stack according to the present invention.

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

In the following figures, axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 2. The Z-direction is parallel to a normal direction to the substrate 2.

In accordance with the above, the first direction (X-direction) may be understood as a direction in which the current of the finished transistors flow. The second direction (Y-direction) may be understood as a direction transverse to the first direction. The third direction (Z-direction) may be understood as the vertical or bottom-up direction. The first and second directions may be parallel to the substrate. The third direction may be normal to the substrate.

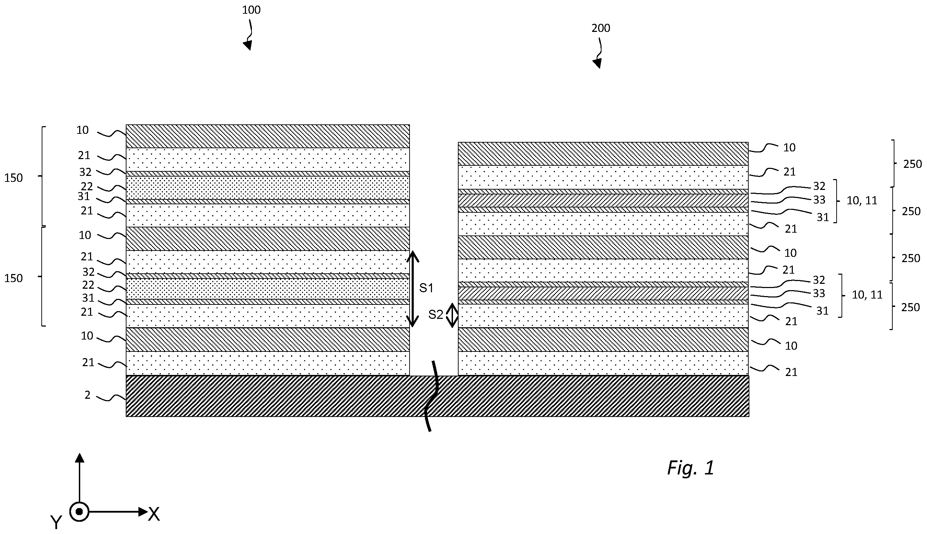

Fig. 1 is a cross-sectional view of a first 100 and a second 200 layer stack on a same substrate 2. The first 100 and second 200 layer stacks may be arranged on parts of the substrate 2 which are not necessarily close together, as indicated by the break line in the substrate 2 between the first 100 and second 200 layer stacks.

The illustrated first layer stack 100 comprises, from the bottom and upwards: a bottom-most sacrificial layer, which in the illustration is of the first type 21; followed by a channel layer 10; followed by two sub-stacks 150 on the channel layer 10. Each of the illustrated two sub-stacks 150 comprises a sacrificial layer of the first type 21, a first slender layer 31 on the sacrificial layer of the first type 21, a sacrificial layer of the second type 22 on the first slender layer 31, a second slender layer 32 on the sacrificial layer of the second type 22, a further sacrificial layer of the first type 21 on the second slender layer 32, and a further channel layer 10 on the further sacrificial layer of the first type 21.

The illustrated second layer stack 200 comprises, from the bottom and upwards: a bottom-most sacrificial layer, which in the illustration is of the first type 21; followed by a channel layer 10 and four sub-stacks 250 on the channel layer 10, wherein each of the four sub-stacks 250 comprises a sacrificial layer of the first type 21 and a further channel layer 10 on the sacrificial layer of the first type 21. In the figure, every second channel layer 10 of the second layer stack 200 is illustrated as a multi-layer channel layer 11. A multi-layer channel layer 11 may be similar or identical to the other channel layers 10 of the second layer stack 200. A multi-layer channel layer 11 may be formed in a process where parts of the first 100 and second 200 layer stack are formed simultaneously, as will be discussed further below. Each illustrated multi-layer channel layer 11 comprises a first slender layer 31 and second slender layer 32, with a third slender layer 33 between the first 31 and second 32 slender layers. However, if a multi-layer channel layer 11 is used, it may alternatively comprise solely the first slender layer 31 and the second slender layer 32.

As illustrated, the separation (S1) between the neighboring channel layers 10 of the first layer stack 100 is larger than the separation (S2) between neighboring channel layers 10, 11 of the second layer stack 200. For example, the separation (S1) between the neighboring channel layers 10 of the first layer stack 100 may be at least a factor two larger (e.g. at least a factor three larger) than the separation (S2) between neighboring channel layers 10, 11 of the second layer stack 200.

Channel layers 10, 11 may have a thickness in the range of 4-10 nm (preferable 5-7 nm). First 31 and second 32 slender layers may have a thickness in the range of 1-4 nm. First 31 and second 32 slender layers may have equal thickness. Sacrificial layers of the first type 21 may have a thickness in the range of 5-10 nm. Sacrificial layers of the second type 22 may have a thickness in the range of 5-10 nm.

In a specific, advantageous, combination of thicknesses: channel layers 10, 11 have a thickness of 9 nm; first 31 and second 32 slender layers each have a thickness of 2 nm; third slender layers have a thickness of 5 nm; sacrificial layers of the first type 21 have a thickness of 9 nm; and sacrificial layers of the second type 22 have a thickness of 9 nm.

The channel layers 10, 11 and the slender layers 31, 32, 33 may comprise Si₁₋ₐGeₐ, while the first sacrificial semiconductor material comprises Si_{1-b}Ge_{b}, and the second sacrificial semiconductor material comprises Si_{1-c}Ge_{c}.

In a specific, advantageous, combination of materials composition ranges for the above mentioned Si₁₋ₐGeₐ, Si_{1-b}Ge_{b}, and Si_{1-b}Ge_{b} may be:
0 ≤ a < 0.05;
0.12 ≤ b ≤ 0.25; and
0.30 ≤ c ≤ 0.60.

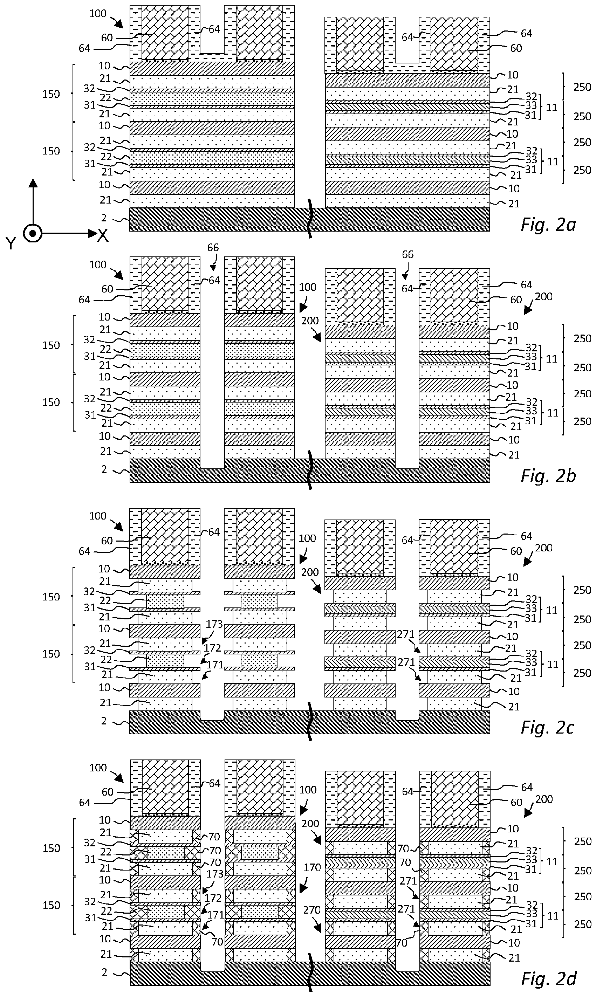

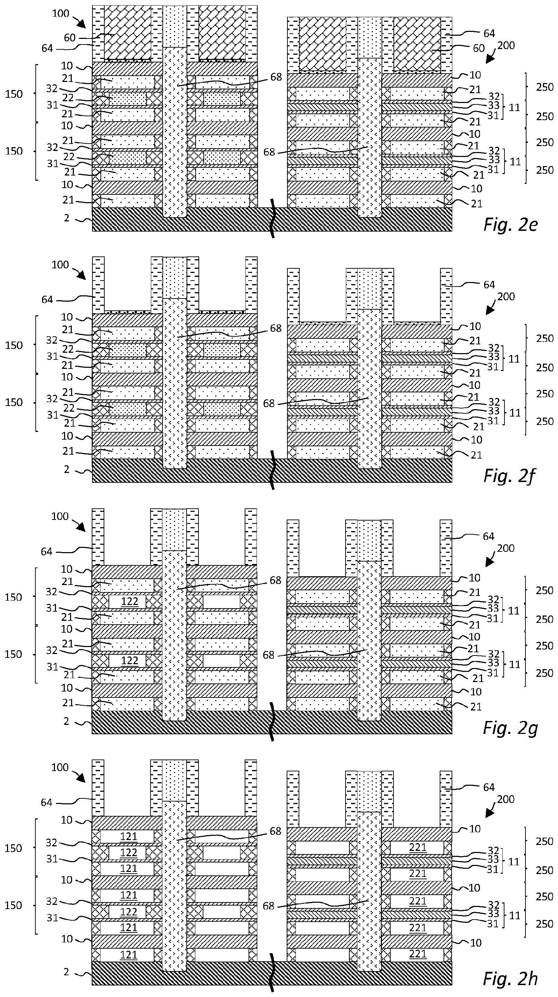

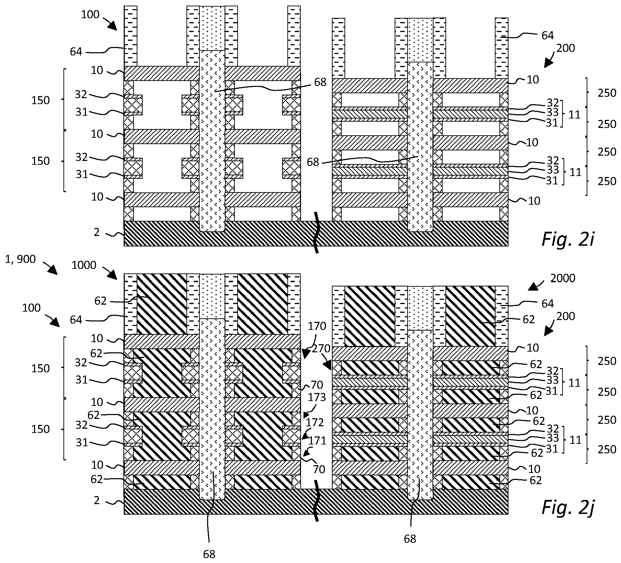

Figs 2a-j will be used to illustrate steps for manufacturing of a co-integrated semiconductor structure 1 in the form of a co-integrated transistor pair 900 according to the invention. The steps may be performed in the order illustrated. In this example, the final product shown in Fig. 2j comprises a co-integrated transistor pair 900 comprising a first 1000 and a second 2000 transistor. In Figs 2a-j, the co-integrated semiconductor structure 1, 900 is formed from first 100 and second 200 layer stacks which are the same as illustrated in Fig. 1 and discussed above. In particular, the first 100 and second 200 layer stacks of Fig. 2 may be seen to comprise layers according to the specific thickness combination and the specific material combination mentioned above. However, it should be understood that other first 100 and second 200 layer stacks may be used. For example, the first layer stack 100 may comprise any number of sub-stacks 150. Similarly, the second layer stack 200 may comprise any number of sub-stacks 250. Further, other thickness combinations or material combinations may be used. The process illustrated in Figs 2a-j is a so-called gate-last process (a.k.a. replacement gate process), wherein the gate stack 62 is formed late or last in the process, e.g. after forming source/drain regions 68. The inventive method may be applicable also in other transistor manufacturing processes, e.g. in gate-first processes.

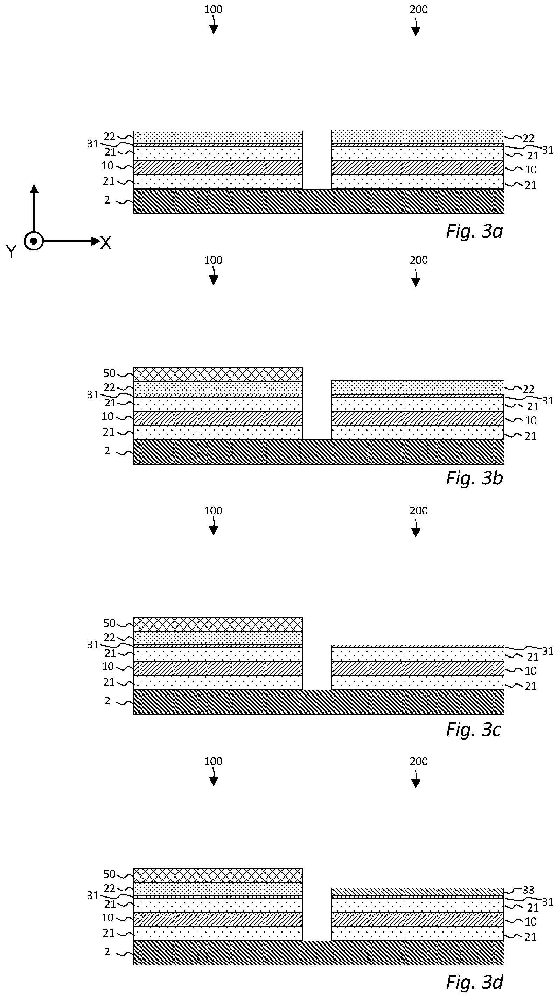

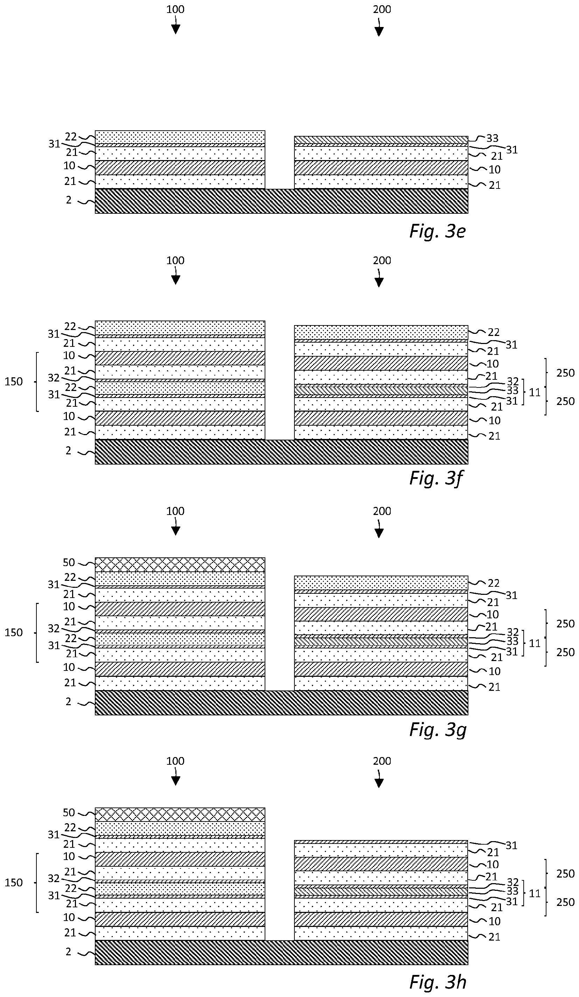

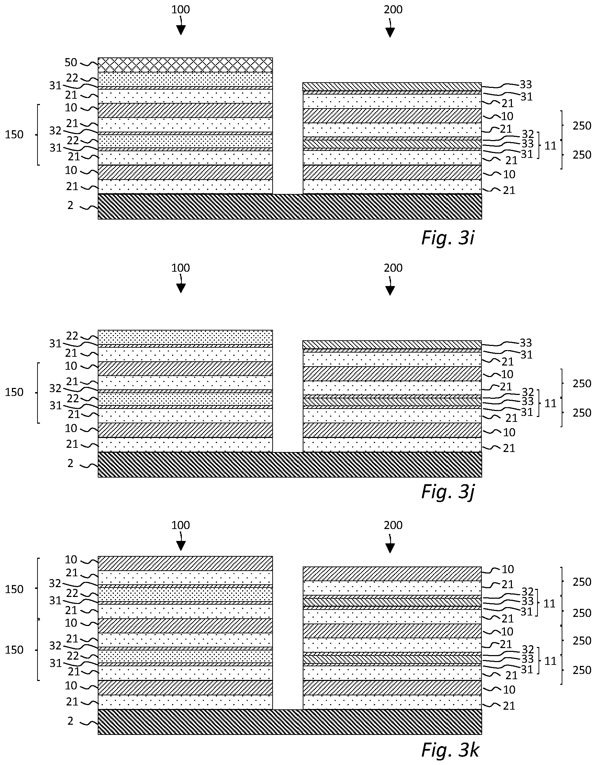

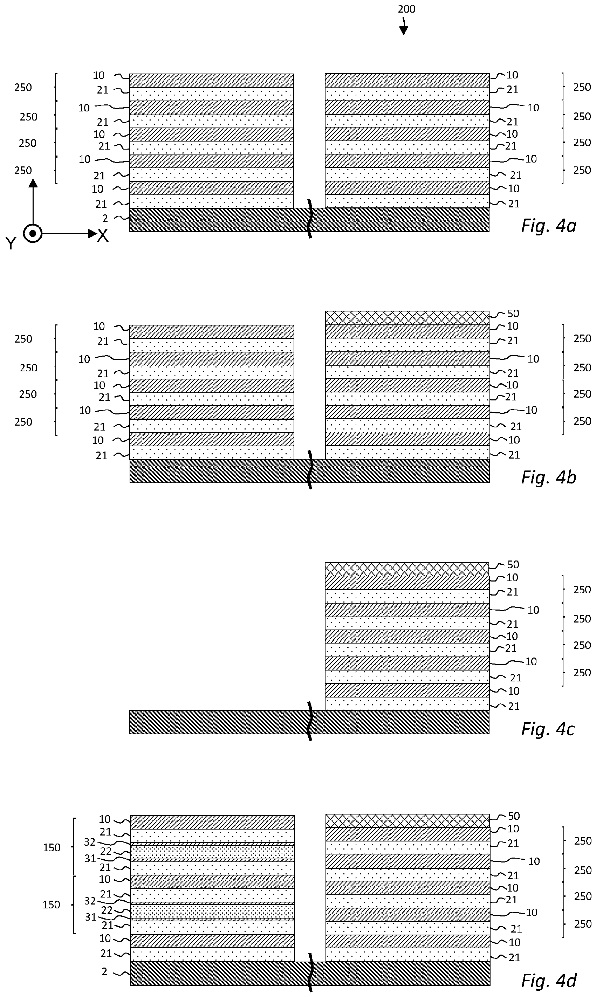

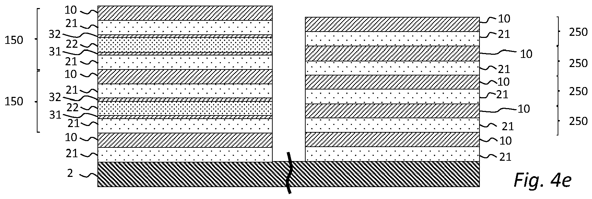

Figs 2a-b schematically illustrate forming of the first 100 and second 200 layer stacks. Further details will be discussed in conjunction with Fig. 3 and 4.

In Fig. 2a, layers for the first 100 and second 200 layer stacks have been formed, e.g. by epitaxial growth. The layers for the first layer stack 100 and the second layer stack 200 may be etched into a respective fin. Dummy gates 60, straddling the respective fins, may subsequently be formed. The dummy gate 60 may define a gate region in which a gate stack 62 will later be formed. Gate spacers 64 may be formed on opposite sides of the dummy gate 60. Fig. 2a illustrates a cross-sectional view through a fin comprising the layers for the first layer stack 100, and through a fin comprising the layers for the second layer stack 200. All of Figs 2a-j show the same cross-sectional plane. In the illustration, the respective fins extend in the X-direction. In the illustration, each fin is straddled by two dummy gates 60 with gate spacers 64. In other words, the dummy gates extend, in the Y-direction, across the fins. The dummy gates 60 may comprise amorphous silicon or polycrystalline silicon. The gate spacers may be formed of dielectric material, e.g. as an oxide, a nitride or a carbide such as SiN, SiC, SiCO, SiCN or SiBCN. The gate spacers may be formed by conformal deposition, e.g. by Atomic Layer Deposition (ALD).

In Fig. 2b, source/drain recesses 66 have been formed. The source/drain recesses 66 may divide the larger fins into smaller fins wherein each smaller fin may be seen as a layer stack. Thus, Fig. 2b illustrates two first layer stacks 100 and two second layer stacks 200, each layer stack having a dummy gate 60 and each dummy gate 60 having two gate spacers 64. The source/drain recesses 66 exposes end surfaces of the respective first 100 and second 200 layer stacks. In the illustration, said end surfaces are normal to the X-direction.

Figs 2c-d illustrate forming of inner spacers 170, 270. In particular, Figs 2c-d illustrate forming of inner spacers 170 of the first layer stack 100 with the advantageous staggered profile that is facilitated by the method.

In Fig. 2c, lateral recesses 171, 172, 173 in the first layer stack 100 have been formed by laterally etching back (e.g. along the X- and negative X-directions) the end surfaces of the sacrificial layers of the first 21 and second 22 types from opposite ends of the first layer stack 100, by selective etching. Similarly, lateral recesses 271 in the second layer stack 100 have been formed by laterally etching back the end surfaces of the sacrificial layers of the first type 21 from opposite ends of the second layer stack 200, by selective etching. The lateral etch back may be achieved by an isotropic etching process. Any suitable dry etching process or wet etching process allowing selective etching of the first sacrificial material may be used (e.g. HCl, or APM).

The selective etching of the first layer stack 100 may be configured to have a lower etch rate for channel layers 10 and slender layers 31, 32 as compared to the etch rate of sacrificial layers of the first 21 and second type 22. The selective etching of the first layer stack 100 may be configured to have a lower etch rate for sacrificial layers of the first type 21 as compared to the etch rate of sacrificial layers of the second type 22. Accordingly, in the first layer stack 100, between neighboring channel layers 10 one may form:
a first lateral recess 171 in the bottom sacrificial layer of the first type 21;
a second lateral recess 172, above the first lateral recess 171, in the sacrificial layer of the second type 22; and
a third lateral recess 173, above the second lateral recess 172, in the top sacrificial layer of the first type 21.

In accordance with the above, and as illustrated, the second lateral recess 172 of the first layer stack may be deeper than the first 171 and third 173 lateral recesses of the first layer stack 100.

As illustrated, the slender layers 31, 32 of the first layer stack 100 may protect the sacrificial layers of the first type 21 during the lateral etch back. This may prevent the etchant from attacking the sacrificial layers of the first type 21 in a vertical direction.

The selective etching of the second layer stack 200 may be configured to have a lower etch rate for channel layers 10 as compared to the etch rate of sacrificial layers of the first 21 and second type 22.

The selective etching of the first 100 and second 200 layer stacks may be performed simultaneously. The selective etching of the first 100 and second 200 layer stacks may be performed by the same etchant.

In Fig. 2d, dielectric material 70 has been deposited in the lateral recesses 171, 172, 173 of the first layer stack 100, thereby forming the inner spacers 170 of the first layer stack 100. Further, dielectric material 70 has been deposited in the lateral recesses 271 of the second layer stack 200, thereby forming the inner spacers 270 of the second layer stack 200. The dielectric material 70 of the inner spacers 170, 270 may be a nitride or a carbide. The dielectric material 70 of the inner spacers 170, 270 may be deposited by conformal deposition.

Figs 2e illustrate forming source/drain regions 68. Source/drain regions 68 may be formed on end faces of the channel layers 10. For each layer stack 100, 200, a source region may be formed at one end face of the channel layers 10 and a drain region may be formed at the opposite end face of the channel layers 10. The figure schematically illustrates one single source/drain region 68 for each layer stack. However, it should be understood that, in addition to the illustrated source/drain regions 68, there may be a source/drain region 68 to the left of the leftmost first layer stack 100 and a source/drain region 68 to the right of the rightmost first layer stack 100. Similarly, there may be a source/drain region 68 to the left of the leftmost second layer stack 200 and a source/drain region 68 to the right of the rightmost second layer stack 200. The source/drain regions 68 may be doped semiconductor regions. The source/drain regions 68 may be epitaxially grown on the end faces of the channel layers 10.

Figs 2f-i illustrate removing, in a gate region of the first layer stack 100, the sacrificial layers of the first 21 and second 22 types and the first 31 and second 32 slender layers of the first layer stack 100, as well as removing, in a gate region of the second layer stack 200, the sacrificial layers of the first type 21 of the second layer stack 200.

In Fig. 2f, the dummy gate 60 has been removed. Removing the dummy gate 60 may expose side surfaces (e.g. surfaces normal to the Y-direction) of the layers of the first 100 and second 200 layer stacks.

In Fig. 2g, the sacrificial layers of the second type 22 have been removed in the gate region. In the figure, spaces 122 are formed by the removed sacrificial layers of the second type 22 of the first layer stack 100.

In Fig. 2h, the sacrificial layers of the first type 21 have been removed in the gate region. In the figure, spaces 121 are formed by the removed sacrificial layers of the first type 21 of the first layer stack 100 and spaces 221 are formed by the removed sacrificial layers of the first type 21 of the second layer stack 200.

The sacrificial layers of the second type 22 may be removed after removing the sacrificial layers of the first type 21, as illustrated. Alternatively, the sacrificial layers of the first 21 and second 22 types may be removed simultaneously.

Sacrificial layers of the first 21 and second 22 types may be removed by any suitable wet or dry etching process allowing selective etching of the sacrificial layers of the first 21 and second 22 types (e.g. HCl, or APM). Thereby, the channel layers 10, 11 may be released. Both the first 100 and second 200 layer stacks may be subjected to the etchant during removal of the sacrificial layers of the first 21 and second 22 types.

In Fig. 2i, the slender layers 31, 32 have been removed in the gate region of the first layer stack 100. Removing the slender layers 31, 32 may be performed by wet or dry etching. Removing the slender layers 31, 32 may be performed in a separate trimming step, e.g. after removing the sacrificial layers of the first 21 and second 22 types. Alternatively, removing the slender layers 31, 32 may be performed during removal of the sacrificial layers of the first 21 and second 22 types.

Fig. 2j illustrates forming a gate stack 62 around the channel layers 10 in the gate region of the first layer stack 100 and forming a gate stack 62 around the channel layers 10 in the gate region of the second layer stack 200. These gate stacks may then be the final gate stacks of the structure. The gate stacks 62 may comprise a gate dielectric layer followed by a gate work function metal (WFM) conformally coating the channel layers 10. Thus, the gate stack 62 may be arranged in a gate all around (GAA) arrangement.

The gate dielectric layer may be formed of an interface layer and a conventional a high-k dielectric e.g. HfO₂, HfSiO, LaO, AlO or ZrO. The WFM may be formed of one or more effective WFMs (e.g. an n-type WFM such as TiAl or TiAlC and/or a p-type WFM such as TiN or TaN). The gate dielectric layer and the WFM may be deposited by ALD.

The gate dielectric layer of the gate stack 62 around the channel layers 10 of the first layer stack 100 may be thicker than the gate dielectric layer of the gate stack 62 around the channel layers 10 of the second layer stack 200. Part of the gate dielectric layer of the gate stack 62 around the channel layers 10 of the first layer stack 100 may be deposited before or after the deposition of the gate dielectric layer of the gate stack 62 around the channel layers 10 of the second layer stack 200.

In the following, the step of forming the layer stacks will be described further.

Figs 3a-k illustrate forming of a first 100 and a second 200 layer stack using simultaneous formation of parts of the first 100 and second 200 layer stacks and Figs 4a-e illustrate separate formation of the first 100 and second 200 layer stacks. In both cases, the layers of the first 100 and second 200 layer stacks may be formed by epitaxial growth.

Figs 3a-k will be used to illustrate forming of a first 100 and a second 200 layer stack using simultaneous formation of parts of the first 100 and second 200 layer stacks. The steps may be performed in the order illustrated. In this example, the final product shown in Fig. 3k comprises first 100 and second 200 layer stacks which are the same as illustrated in Fig. 1 and discussed above. In particular, the first 100 and second 200 layer stacks of Fig. 3k may be seen to comprise layers according to the specific thickness combination and the specific material combination mentioned above. However, it should be understood that other first 100 and second 200 layer stacks may be used. For example, the first layer stack 100 may comprise any number of sub-stacks 150. Similarly, the second layer stack 200 may comprise any number of sub-stacks 250. Further, other thickness combinations or material combinations may be used.

Fig. 3a illustrates, in both a partial first layer stack 100 and in a partial second layer stack 200 (during production), from bottom to top: a sacrificial layer of the first type 21; a channel layer 10; a sacrificial layer of the first type 21; a first slender layer 31; and a sacrificial layer of the second type 22. The illustrated partial first layer stack 100 and partial second layer stack 200 may be formed simultaneously. In particular, the first slender layers 31 of the respective layer stacks may be formed simultaneously.

Figs 3b-c illustrates the removal of the sacrificial layer of the second type 22 from the first slender layer 31 of the second layer stack 200. In the illustration, this is done by forming a mask 50 on the first layer stack 100, in Fig. 3b, and then removing the sacrificial layer of the second type 22 from the first slender layer 31 of the second layer stack 200 in Fig. 3c. Removing the sacrificial layer of the second type 22 may be done by selective etching. The mask 50 may protect the sacrificial layer of the second type 22 in the first layer stack 100.

Fig. 3d illustrates the forming of a third slender layer 33 on the first slender layer 31 of the second layer stack 200. The mask 50 may protect the first layer stack 100 such that no third slender layer 33 is deposited on the first layer stack 100.

Fig. 3e illustrates subsequent removal of the mask 50.

Fig. 3f illustrates subsequent formation of the following layer sequence in both the first 100 and second 200 layer stacks, from bottom to top: a second slender layer 32; a sacrificial layer of the first type 21; a channel layer 10; a sacrificial layer of the first type 21; a first slender layer 31; and a sacrificial layer of the second type 22.

The, in Fig. 3f, added layer sequences of the first layer stack 100 and the second layer stack 200 may be formed simultaneously. In particular, the second slender layer 32 added to the first layer stack 100 may be formed simultaneously with the second slender layer 32 added to the second layer stack 200. In particular, the first slender layer 31 added to the first layer stack 100 may be formed simultaneously with the first slender layer 31 added to the second layer stack 200.

Figs 3g-h illustrate the removal of the sacrificial layer of the second type 22 from the topmost first slender layer 31 of the second layer stack 200. In the illustration, this is done by forming a mask 50 on the first layer stack 100, in Fig. 3g, and then removing the sacrificial layer of the second type 22 from the topmost first slender layer 31 of the second layer stack 200 in Fig. 3h. Removing the sacrificial layer of the second type 22 may be done by selective etching. The mask 50 may protect the sacrificial layer of the second type 22 in the first layer stack 100.

Fig. 3i illustrates the forming of a third slender layer 33 on the first slender layer 31 of the second layer stack 200. The mask 50 may protect the first layer stack 100 such that no third slender layer 33 is deposited on the first layer stack 100.

Fig. 3j illustrates subsequent removal of the mask 50.

Fig. 3k illustrates the formation of a further channel layer 10 on both the first 100 and second 200 layer stacks. In the second layer stack 200 of Fig. 3k two multi-layer channel layers 11 are formed, each comprising a third slender layer 33 sandwiched between a first 31 and a second 32 slender layer. If the third slender layers 33 had been omitted from the above process, the multi-layer channel layers 11 would have comprised solely a first 31 and a second 32 slender layer.

Figs 4a-e will be used to illustrate separate formation of the first 100 and second 200 layer stacks, i.e. formation of the first 100 layer stack independently of the second 200 layer stack The steps may be performed in the order illustrated. In this example, the final product shown in Fig. 4e comprises first 100 and second 200 layer stacks which are the same as illustrated in Fig. 1 and discussed above. In particular, the first 100 and second 200 layer stacks of Fig. 3k may be seen to comprise layers according to the specific thickness combination and the specific material combination mentioned above. However, it should be understood that other first 100 and second 200 layer stacks may be used. For example, the first layer stack 100 may comprise any number of sub-stacks 150. Similarly, the second layer stack 200 may comprise any number of sub-stacks 250. Further, other thickness combinations or material combinations may be used.

Fig. 4a illustrates a second layer being formed on one part of the substrate 2 (in the figure, to the right on the substrate). An identical layer stack has been formed on another part of the substrate 2 (in the figure, to the left on the substrate), this layer stack is unwanted. The two layer stacks may be formed simultaneously.

Figs 4b-c illustrates the removal of the unwanted layer stack (in the illustration to the left). In the illustration, this is done by forming a mask 50 on the second layer stack 200, in Fig. 4b, and then removing the unwanted layer stack in Fig. 3c. Removing the unwanted layer stack may be done by etching. The mask 50 may protect the second layer stack 200.

Fig. 4d illustrates the forming of a first layer stack 100. The mask 50 may protect the second layer stack 200 such that no further layers are deposited on the second layer stack 200.

Fig. 4e illustrates subsequent removal of the mask 50. The structure shown in Fig. 4e may be used as a starting point for the process discussed in Fig. 2a-j. Thus, after fig. 4e, the gate stack formation and inner spacer formation may be done similar to the process discussed in Fig. 2a-j.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for manufacturing a co-integrated semiconductor structure (1), the method comprising
forming, on a same substrate (2), a first (100) and a second (200) layer stack,
the first layer stack (100) comprising a channel layer (10) and at least one sub-stack (150) on the channel layer (10), wherein each of the at least one sub-stack (150) comprises a sacrificial layer of a first type (21), a first slender layer (31) on the sacrificial layer of the first type (21), a sacrificial layer of a second type (22) on the first slender layer (31), a second slender layer (32) on the sacrificial layer of the second type (22), a further sacrificial layer of the first type (21) on the second slender layer (32), and a further channel layer (10) on the further sacrificial layer of the first type (21),
the second layer stack (200) comprising a channel layer (10) and at least one sub-stack (250) on the channel layer (10), wherein each of the at least one sub-stack (250) comprises a sacrificial layer of the first type (21) and a further channel layer (10, 11) on the sacrificial layer of the first type (21),
wherein a separation (S1) between the neighboring channel layers (10) of the first layer stack (100) is larger than a separation (S2) between neighboring channel layers (10, 11) of the second layer stack (200);
wherein the slender layers (31, 32) and the channel layers (10) are formed of a same semiconductor channel material, the slender layers (31, 32) being thinner than the channel layers (10);
wherein the sacrificial layers of the first type (21) are formed of a first sacrificial semiconductor material different from the semiconductor channel material;
wherein the sacrificial layer of the second type (22) is formed of a second sacrificial semiconductor material different from the semiconductor channel material and different from the first sacrificial semiconductor material;
the method further comprising:
removing, in a gate region of the first layer stack (100), the sacrificial layers of the first (21) and second (22) types and the first (31) and second (32) slender layers of the first layer stack (100);
removing, in a gate region of the second layer stack (200), the sacrificial layers of the first type (21) of the second layer stack (200);
thereafter
forming a gate stack (62) around the channel layers (10) in the gate region of the first layer stack (100); and
forming a gate stack (62) around the channel layers (10) in the gate region of the second layer stack (200).

2. The method according to claim 1, wherein a dielectric of the gate stack (62) around the channel layers (10) of the first layer stack (100) is thicker than a dielectric of the gate stack (62) around the channel layers (10) of the second layer stack (200).

3. The method according to claim 1 or 2, wherein the semiconductor channel material of the channel layers (10) and the slender layers is Si₁₋ₐGeₐ, the first sacrificial semiconductor material is Si_{1-b}Ge_{b}, and the second sacrificial semiconductor material is Si_{1-c}Ge_{c}, wherein 0 ≤ a < b < c.

4. The method according to claim 3, wherein
0 ≤ a < 0.05;
0.12 ≤ b ≤ 0.25; and
0.30 ≤ c ≤ 0.60.

5. The method according to any one of the preceding claims, wherein the channel layer of at least one of the at least one sub-stack (250) of the second layer stack (200) is a multi-layer channel layer (11), the multi-layer channel layer (11) being formed from at least a first and second slender layer,
the first slender layer (31) of the multi-layer channel layer (11) of the second layer stack (200) being formed simultaneously with the first slender layer (31) of the first layer stack (100); and
the second slender layer (32) of the multi-layer channel layer (11) of the second layer stack (200) being formed simultaneously with the second slender layer (32) of the first layer stack (100).

6. The method according to claim 5, wherein forming the first (100) and second (200) layer stacks comprises:
forming, simultaneously, the first slender layer (31) of the first layer stack (100) and the first slender layer (31) of the multi-layer channel layer (11) of the second layer stack (200);
subsequently, simultaneously forming the sacrificial layer of the second type (22) on the first slender layer (31) of the first layer stack (100) and the sacrificial layer of the second type (22) on the first slender layer (31) of the multi-layer channel layer (11) of the second layer stack (200);
subsequently removing the sacrificial layer of the second type (22) from the first slender layer (31) of the multi-layer channel layer (11) of the second layer stack (200);
subsequently forming, simultaneously, the second slender layer (32) of the first layer stack (100) and the second slender layer (32) of the multi-layer channel layer (11) of the second layer stack (200).

7. The method according to claim 6, wherein said act of removing the sacrificial layer of the second type (22) from the first slender layer (31) of the second layer stack (200) is performed by wet etching.

8. The method according to any one of claims 5-7, further comprising forming a third slender layer (33) between the first (31) and second (32) slender layers of the multi-layer channel layer (11) of the second layer stack (200).

9. The method according to any one of the preceding claims, wherein the channel layers (10) of the first (100) and second (200) layer stack have a same thickness.

10. The method according to any one of the preceding claims, further comprising:
forming source/drain recesses (66), the source/drain recesses (66) exposing end surfaces of the respective first (100) and second (200) layer stack;
forming lateral recesses (171, 172, 173) in the first layer stack (100) by laterally etching back the end surfaces of the sacrificial layers of the first (21) and second (22) types from opposite ends of the first layer stack (100), by selective etching;
forming lateral recesses (271) in the second layer stack (200) by laterally etching back the end surfaces of the sacrificial layer of the first type (21) from opposite ends of the second layer stack (200), by selective etching;
forming inner spacers between end parts of neighbouring channel layers of the respective first (100) and second (200) layer stacks, the inner spacers comprising dielectric material (70) deposited in the lateral recesses;
wherein the lateral recesses of the first (100) and second (200) layer stacks are formed simultaneously and the inner spacers (170, 270) of the first (100) and second (200) layer stacks are formed simultaneously.

11. The method according to any one of the preceding claims,
wherein, in the gate region of the first layer stack (100), the first (31) and second (32) slender layers are removed subsequent to removing the sacrificial layers of the first (21) and second (22) types.

12. The method according to any one of the preceding claims, further comprising:
incorporating the channel layers (10) of the first layer stack (100) in an Input/Output, I/O, transistor; and
incorporating the channel layers (10, 11) of the second layer stack (200) in a core transistor.

13. The method according to any one of the preceding claims, further comprising:
arranging the first layer stack (100) at a peripheral part of the substrate (2); and
arranging the second layer stack (200) at a central part of the substrate (2).

14. A co-integrated semiconductor structure (900) comprising, on a same substrate (2), a first (1000) and a second (2000) transistor,
the first transistor (1000) comprising
a first layer stack (100) comprising at least two channel layers (10);
a gate stack (62) around each of the two channel layers (10) in a gate region of the first layer stack (100); and
an inner spacer (170) arranged vertically between end parts of the two channel layers (10) of the first layer stack (100), the inner spacer (170) of the first layer stack (100) comprising a first lateral recess (171) , a second lateral recess (172) above the first lateral recess (171), and a third lateral recess (173) above the second lateral recess (172), the first (171), second (172) and third (173) lateral recesses being filled with dielectric material (70);
the second transistor (2000) comprising
a second layer stack (200) comprising at least two channel layers (10, 11);
a gate stack (62) around each of the two channel layers (10, 11) in a gate region of the second layer stack (200); and
an inner spacer (270) arranged vertically between end parts of the two channel layers of the second layer stack (200), the inner spacer (270) of the second layer stack (200) comprising a first lateral recess (271) filled with dielectric material (70);
wherein a separation (S1) between neighboring channel layers (10) of the first layer stack (100) is larger than a separation (S2) between neighboring channel layers (10, 11) of the second layer stack (200); and
wherein the second lateral recess (172) of the first layer stack (100) is separated from the first (171) and third (173) lateral recesses of the first layer stack (100) by respective slender layers (31, 32), the slender layers (31, 32) and the channel layers (10) of the first layer stack being formed of a same semiconductor channel material, the slender layers (31, 32) being thinner than the channel layers (10); or
wherein the second lateral recess (172) of the first layer stack is deeper than the first (171) and third (173) lateral recesses of the first layer stack (100).

15. The co-integrated semiconductor structure according to claim 14,
wherein a dielectric of the gate stack of the first layer stack (100) is thicker than a dielectric of the gate stack of the second layer stack (200).
